# EUROPEAN PATENT APPLICATION

(11) **EP 4 439 662 A1**
(43) Date of publication of application: **02.10.2024**
(21) Application number: 23216585.2
(22) Date of filing: 14.12.2023
(51) Int. Cl.: H01L 23/538, H01L 25/065, H01L 23/498

(54) **INTERCONNECT BRIDGE CIRCUITRY DESIGNS FOR INTEGRATED CIRCUIT PACKAGE SUBSTRATES**

(30) Priority: 30.03.2023 US 202318192804
(71) Applicant: Intel Corporation, Santa Clara, CA 95054 (US)
(72) Inventor: Wang, Lijiang, Chandler, 85249 (US); Sharan, Sujit, Chandler, 85286 (US)
(74) Representative: Goddar, Heinz J.

(57) **Abstract**

In one embodiment, an interconnect bridge circuitry includes a first set of bridge-to-die electrical connectors in a first region of the circuitry, a second set of bridge-to-die electrical connectors in a second region of the circuitry, and an interconnection between a bridge-to-die connector of the first set and a bridge-to-die connector of the second set. The interconnection is in a third region of the circuitry between the first region and the second region, and includes a first trace connected to the bridge-to-die electrical connector of the first set, a second trace connected to the bridge-to-die electrical connector of the second set, the second trace parallel with the first trace, and a third trace connected between the first trace and the second trace.

## Description

### BACKGROUND

Integrated circuit packages may utilize interconnect bridge circuitry to interconnect multiple dies on a package substrate. In some cases, the interconnect bridge circuitry may be implemented as a die embedded within a package substrate. The interconnect bridge circuitry can enable interconnects with a high input-output (IO) density for heterogeneous chips on the same integrated circuit package. For example, interconnect bridge circuitries can be used for connecting multiple chiplet dies of a system-on-chip (SoC), such as a field programmable gate array (FPGA), serializer/deserializer (SerDes), high-performance analog-to-digital converters (ADC), digital-to-analog converter (DAC), or other types of chiplet dies.

### BRIEF DESCRIPTION OF THE DRAWINGS

FIG. 1 illustrates an example multi-chip integrated circuit package incorporating bridge circuitry within a package substrate in accordance with embodiments herein.
FIGS. 2A-2B illustrate top views of different multi-chip integrated circuit die packaging architectures.
FIGS. 3A-3B illustrate a top view of different shoreline layouts for an embedded bridge circuitry.
FIGS. 4-6 illustrate example interconnect bridge circuitry designs in accordance with embodiments herein.
FIGS. 7A-7B illustrate top and side views, respectively, of a die-to-die interconnect of a bridge circuitry in accordance with embodiments herein.
FIG. 8 is a top view of a wafer and dies that may be included in a microelectronic assembly, in accordance with any of the embodiments disclosed herein.
FIG. 9 is a cross-sectional side view of an integrated circuit device assembly that may include embodiments disclosed herein.
FIG. 10 is a cross-sectional side view of an integrated circuit device that may be included in a microelectronic assembly, in accordance with any of the embodiments disclosed herein.
FIG. 11 is a block diagram of an example electrical device that may include a microelectronic assembly, in accordance with any of the embodiments disclosed herein.

### DETAILED DESCRIPTION

Embodiments herein provide an improved shoreline layout design for interconnect bridge circuitries of integrated circuit packages. The bridge circuitry shoreline layouts described herein may be implemented in a bridge circuitry die (e.g., one that may be embedded in a package substrate) that interconnects various logic dies, memory dies, or other types of "chiplets" on the same integrated circuit package. Certain embodiments may be implemented as an interconnect bridge circuitry die that is embedded within the package substrate, and may be implemented similar to, e.g., an Intel^{®} Embedded Multi-Die Interconnect Bridge (EMIB) die. Although many examples described herein include an embedded interconnect bridge circuitry die (which may also be referred to as a bridge circuitry die or bridge die), aspects of the present disclosure may be implemented as circuitry within the upper layers of the package substrate rather than as an embedded die solution.

These bridge circuitries include die-to-die electrical connections between "shorelines" of bridge-to-die (or die-to-bridge) electrical connectors (e.g., electrical contact bumps or pads of a die) that are located on different sides of the bridge circuitry. These die-to-die connections provide the interconnections between two integrated circuit dies of an integrated circuit package (e.g., between chiplets of a system-on-chip (SoC) package). As used herein, a shoreline may refer to the bridge-to-die electrical connectors (e.g., contact pads on the surface of an interconnect bridge circuitry die). In some cases, a shoreline may also refer to the spacing of the bridge-to-die electrical connectors, e.g., the number of connectors per unit space or length of the side of a die.

In many cases, the shorelines of a bridge circuitry die may be matched on each side of the die, i.e., the number of connectors per unit space may be the same for two shorelines of a bridge circuitry die and/or the connectors may be aligned with one another. However, due to increasing demand for interoperability with various integrated circuit chips, certain bridge circuitry dies might have shoreline dimensions that are not matched on the two sides of the die. In cases where the shoreline dimensions differ (e.g., the number of connectors per unit space/length), the offset between the different shoreline dimensions can accumulate over the length of the die. In some cases, for example, an overall channel offset may be up to 1mm for a 24-channel Intel^{®} AIB-UCIe (Advanced Interface Bus-Universal Chiplet Interconnect Express) die interoperability design scenario.

Accordingly, embodiments herein provide interconnect bridge circuitry designs that enable die interoperability for dies having different channel shorelines/shoreline dimensions. In particular, embodiments herein may provide for a dedicated die-to-die region that includes signal routing jogs with a cautiously planned hierarchical routing strategy and one or more other dedicated regions in which other circuitry may be located, e.g., power distribution signaling/routing (e.g., power/ground bumps) and/or power meshes. Some embodiments may implement intentionally offset shorelines on two sides of the interconnect bridge circuitry layout to increase the chiplet die-to-die spacing. Thus, embodiments can enable die interoperability for various types of dies having different channel shorelines, and can relieve package design constraints and cost pressures that currently exist. In addition, some embodiments can also reduce package layer counts for the interconnect bridge circuitry.

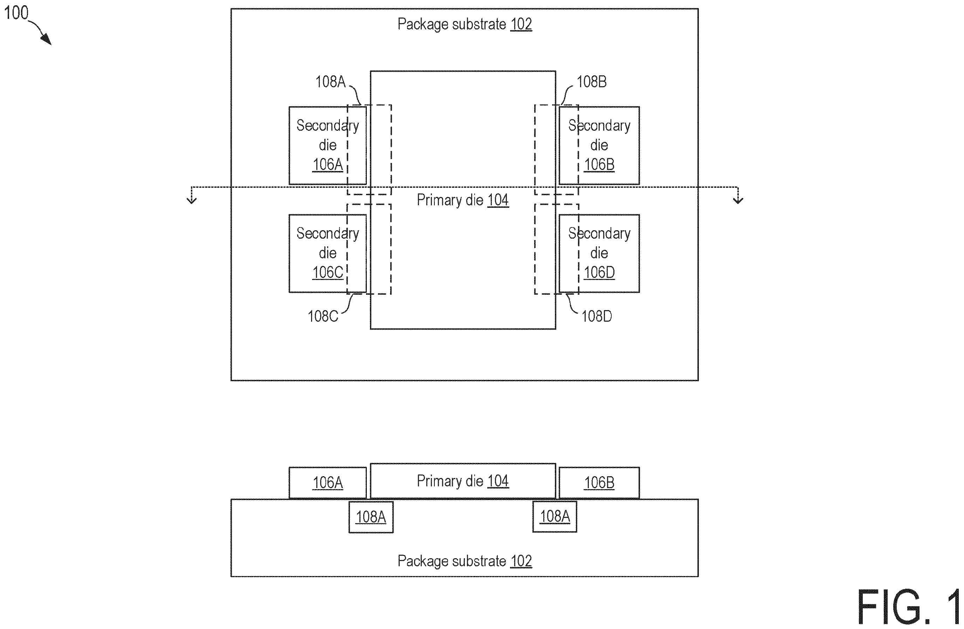

FIG. 1 illustrates an example multi-chip integrated circuit package 100 incorporating bridge circuitry 108 within a package substrate 102 in accordance with embodiments herein. The package 100 includes a package substrate 102 with a primary die 104 and multiple secondary dies 106 (which may also be referred to as "chiplets" in some instances) coupled to the package substrate 102. In various embodiments, the primary die 104 may include logic and other circuitry to implement a field programmable gate array (FPGA) fabric, while the secondary dies 106 may be implemented as one or more of a high bandwidth memory (HBM) die, transceiver die (e.g., high speed serial interfaces (HSSI)), or another type of logic circuit (e.g., processor) die, and may include logic and other circuitry to implement such functions.

The package substrate 102 may include circuitry to connect the dies 104, 106 to a main circuit board (e.g., motherboard or main board) and/or to interconnect the dies 104, 106 with one another. For example, the package substrate 102 may include connections for signaling between the main circuit board and the dies 104 and/or 106, as well as connections for providing power delivery from the main circuit board (e.g., from a power supply coupled to the main circuit board) to the dies 104 and/or 106. Further, in some embodiments, the package substrate 102 may include one or more interconnect bridge circuitries 108 that interconnect two or more of the dies 104, 106. The bridge circuitries 108 may be implemented, in certain instances, as dies that are embedded within the package substrate 102. However, other embodiments may implement the interconnect bridge circuitry as circuitry within upper layers of the package substrate 102. The interconnect bridge circuitries 108 may include any suitable passive and/or active circuitry to interconnect a one of the secondary dies 106 with the primary die 104. An example implementation of an interconnect bridge circuitry is an Intel^{®} Embedded Multi-Die Interconnect Bridge (EMIB) die.

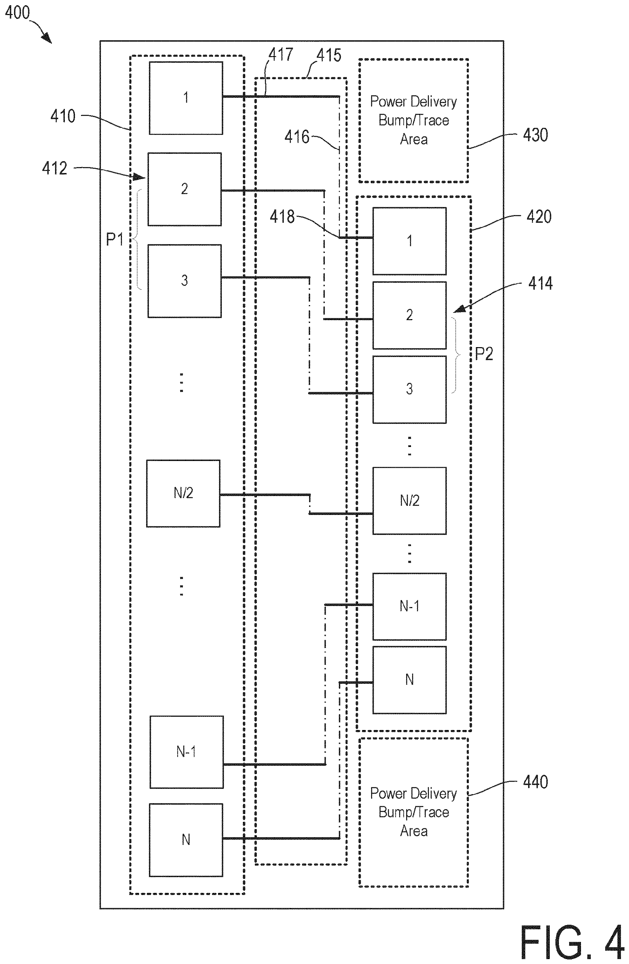

In many current designs, the shorelines of the interconnect bridge circuitry dies 108 may be matched on each side, i.e., the shoreline of connectors (e.g., bumps/pads) to connect the die 108 to the die 104 are the same (e.g., in connector density) as the shoreline of connectors to connect the die 108 to the die 106. A matched shoreline may be used where, for instance, the connector pitch (the distance between respective connectors) is the same for both dies 106. However, in embodiments herein, the interconnect bridge circuitry dies 108 may implement different shorelines on each side of the die 108, e.g., as shown in FIGS. 4-6 and described below. The interconnect bridge circuitry dies 108 may include a dedicated region for signal routing between the shorelines of the dies 108 and one or more dedicated regions for other purposes, e.g., power delivery bumps, traces, and/or power meshes in the dies 108.

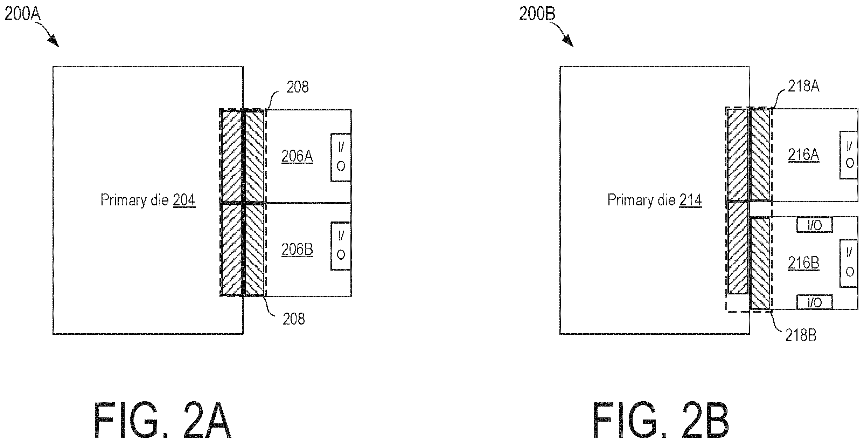

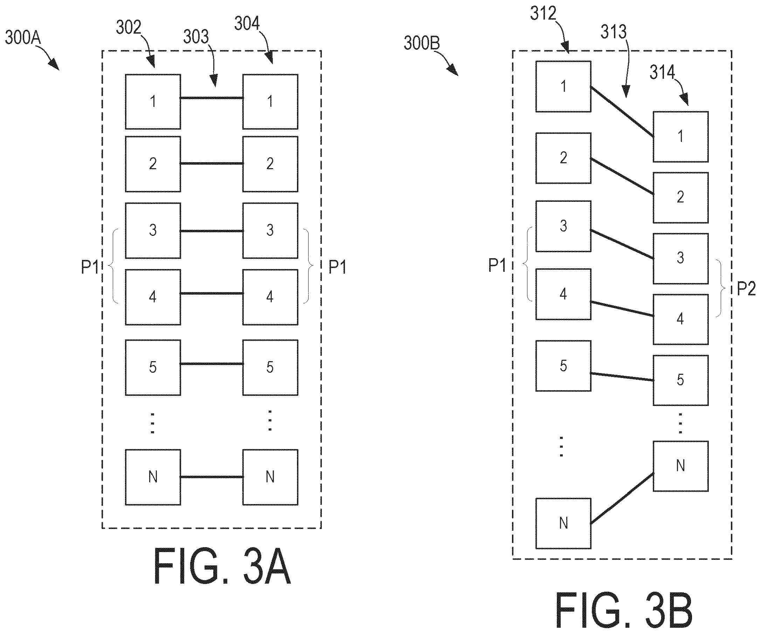

FIGS. 2A-2B illustrate top views of different multi-chip integrated circuit die packaging architectures 200. In particular, FIG. 2A illustrates an integrated circuit package architecture 200A with interconnect bridge circuitries 208 interconnecting a primary die 204 and secondary dies 206. The interconnect bridge circuitries 208 are implemented with a single ("one-sided") IO interface is implemented in each of the secondary dies 206. In the package architecture 200A, the die-to-die spacing between the secondary dies 206 is very narrow, meaning that few of the interconnect signal lines in the circuitries 208 can "break out". Accordingly, the die 208 may implement a shoreline-aligned design such as that shown in FIG. 3A (where the shoreline density is the same on each side of the circuitries 208) or a design such as that shown in FIG. 3B (where the shoreline densities on each side of the circuitries 208 are different). However, in some instances, the primary die 204 may be designed to be paired with various types of secondary dies 206, e.g., as an FPGA die that can be paired to various types of chiplets, and a shoreline-aligned design might not be optimal for such flexible primary die designs.

FIG. 2B illustrates an integrated circuit package architecture 200B with interconnect bridge circuitry dies 218 interconnecting a primary die 214 and secondary dies 216, similar to the architecture 200A. However, in the example shown, the secondary die 216A implements a single IO interface, while the secondary die 216B implements multiple IO interfaces on various sides of the die 216B. A narrow die-to-die spacing as shown in FIG. 2A would only allow a few of the IO signals to break out. To allow for additional IO signal break out, the package and/or bridge circuitry die 218 layer count would need to be increased, which would increase the complexity and cost of the package and/or die. Moreover, signaling performance degradation may be seen from the additional vertical via transitions in the increased layer count. Thus, certain embodiments may implement an intentionally offset shoreline design, e.g., as shown in the interconnect bridge circuity die 218B.

FIGS. 3A-3B illustrate a top view of different shoreline layouts 300 for an interconnect bridge circuitry (e.g., the circuitries 208 or 218A of FIGS. 2A and 2B, respectively). The layout 300A includes a first set of bridge-to-die electrical connectors 302 (which may, in some instances, be referred to as "channels") on a first side of the interconnect bridge circuitry die and a second set of bridge-to-die electrical connectors 304 on a second side of the interconnect bridge circuitry die, with signal lines 303 connecting the connectors 302, 304 together. The bridge-to-die electrical connectors 302, 304 may be, for example, electrical bumps or pads on the die, while the signal lines 303 may be conductive traces within one or more layers of the die. As shown, the shoreline of connectors 302 is the same as the shoreline of connectors 304, i.e., the density of connectors 302, 304 is the same per unit of length on the die. As such, the layout 300A may be considered a channel-aligned layout.

Like the layout 300A, the layout 300B includes a first set of bridge-to-die electrical connectors 312 on a first side of the interconnect bridge circuitry die and a second set of bridge-to-die electrical connectors 314 on a second side of the interconnect bridge circuitry die, with signal lines 313 connecting the connectors 312, 314 together. However, in contrast to the layout 300A, the shoreline of connectors 312 is different from the shoreline of connectors 314, i.e., the pitch of the connectors 312 (P1) is larger than the pitch of the connectors 314 (P2). The shoreline of connectors 314 is more dense than the shoreline of connectors 312, since the shoreline of connectors 314 takes up less space/length on the die than the shoreline of connectors 312 (each shoreline has the same number of connectors). In the example shown, the signal lines 313 are fanned out based on the shoreline mismatch, causing a continuous incremental channel-to-channel offset increase along the shoreline of connectors 312, as shown. That is, the offset value for each pair of connectors 312, 314 will be different, and may, in certain instances, be as large as 1mm (for a 24 channel AIB-UCIe die design). Besides the channel-to-channel offset, the one-to-one bump signal lines 313 for the same channel will not be aligned due to the different IO depths for the two dies to be connected to the interconnect bridge circuitry die.

The example layouts 300 shown in FIGS. 3A-3B may not allow for increased die-to-die spacing, such as that shown in FIG. 2B, which could require additional routing layers within the die to allow for breakout of connections for other IO interfaces of a die, e.g., as described above. Further, the example layouts 300 may not provide for the most efficient use of die space in the interconnect bridge circuitry die.

Accordingly, in embodiments herein, a dedicated region or region may be included in an interconnect bridge circuitry (e.g., in a ground layer or another layer of a bridge circuitry die) in which traces (which may also be referred to as "jogs") may be run. That is, the route for each die-to-die interconnection is partitioned into three sections: a first bump field in which a first set of bridge-to-die electrical connectors are run, a second bump field in which a second set of bridge-to-die electrical connectors are run, and a jog field in which a set of traces are run to connect the first set of bridge-to-die connectors and the second set of bridge-to-die connectors. The traces in the jog field may be run in a direction orthogonal to traces extending from the bridge-to-die electrical connectors (e.g., bumps/pads), and the length of jogs can be precalculated based on a bump-to-bump offset within and among the bridge-to-die electrical connectors. In this way, the bridge-to-die electrical connectors and trace routing for an interconnect bridge circuitry design within each of the first and second bump fields can remain generally the same for each type of bridge-to-die connector shoreline that can be implemented within the bridge circuitry design, so that various different bridge circuitry designs can be implemented using the same bridge-to-die connector shorelines just with different jog field trace routing.

Furthermore, in certain embodiments, this sort of routing scheme can allow for one or more other regions of the interconnect bridge circuitry design to be dedicated for power delivery connections and/or traces. For example, certain regions outside of the bump fields and jog field can be dedicated for power bumps, ground bumps, and/or power meshes of the interconnect bridge circuitry design. This can allow for enhanced power delivery performance in an integrated circuity package.

FIGS. 4-6 illustrate example interconnect bridge circuitry designs in accordance with embodiments herein. In particular, the examples shown in FIGS. 4-6 illustrate top views of example designs for interconnect bridge circuitry dies that may be embedded within a package substrate of an integrated circuit package, e.g., similar to the interconnect bridge circuitries 108 of FIG. 1 or interconnect bridge circuitries 208, 218 or FIGS. 2A-2B. Each design includes a first set of bridge-to-die connectors (first shoreline) within a first region of the die, a second set of bridge-to-die connectors (second shoreline) within a second region of the die on an opposite side of the die, and a set of traces or jogs within a third region of the die between the first region and second region. The bridge-to-die connectors shown may be implemented as electrical contact pads or bumps on a top surface of the die, and the traces/jogs provide interconnections between the first shoreline and second shoreline. The traces/jogs in each example run orthogonal to traces that extend from the bridge-to-die connectors of the first and second shorelines. The traces/jogs within the third region may be run in a single dedicated layer of the bridge circuitry die, or within multiple layers of the bridge circuitry die.

Referring to FIG. 4, the interconnect bridge circuitry design 400 includes a first region 410 that includes a first shoreline of N bridge-to-die connectors 412, a second region 420 that includes a second shoreline of N bridge-to-die connectors 414, and a third region 415 between the first region 410 and the second region 420 that includes jogs (e.g., 416) interconnecting the traces (e.g., 417) extending from the first connectors and the traces (e.g., 418) extending from the second connectors. In the example shown, the first shoreline of connectors 412 has a lower "density" of connectors than the second shoreline of connectors 414, since each shoreline has the same number of connectors, but the first shoreline is spaced over a longer length of the design 400. That is, the pitch of the connectors 412 (P1) is larger than the pitch of the connectors 414 (P2).

There are also two regions 430, 440 in the design 400 that are dedicated for placement of power delivery bumps, traces, and/or power meshes, e.g., as described above. For example, the regions 430, 440 may include bumps to connect to a die (e.g., 104 and/or 106) as well as vias and/or traces to deliver a power signal or ground signal from a package substrate (e.g., 102) to the die (e.g., power provided by a power supply coupled to a main circuit board to which the package substrate is coupled). The regions 430, 440 may also include one or more power meshes, which may include a mesh of alternating power/ground signal traces to provide power to an integrated circuit die coupled to the bridge circuitry.

The regions 430, 440 are located on the same side of the layout as the second shoreline due to the second shoreline's higher density of connectors than the first shoreline.

Further, in the example shown, the traces (e.g., 417, 418) extend from the connectors 412, 414 in a direction toward the opposite shoreline of connectors such that the traces 412, 414 are parallel with one another. The jogs (e.g., 416) connecting the traces 417, 418, and are run in an orthogonal direction to the traces 417, 418; however, in other embodiments, the jobs 416 might not be orthogonal to the traces 417, 418. In some embodiments, the jogs 416 may be run on the same layer as the traces 417, 418 (e.g., each may be run on the top surface, or in a particular metallization layer with the interconnect bridge circuitry), while in other embodiments, the jogs 416 may be run in a different layer from one or both of the traces 417, 418 (e.g., the traces 417, 418 may be run in a first layer (e.g., top layer or internal metallization layer) of the bridge circuitry and the jogs 416 may be run in another layer (e.g., a different internal metallization layer) of the bridge circuitry and may be connected to the traces 417, 418 through vias in the bridge circuitry). Adjacent pairs of jogs in the design 400 have a particular difference in length across the layout, and more particularly, the jogs of the design 400 of FIG. 4 have incrementally longer lengths the further they are from the middle of the layout. For instance, in the example shown, the jog between the connectors labeled "1" and "N" may be the same or approximately the same and may be much longer than the jog connecting the connectors labeled "N/2" closer to the middle of the layout.

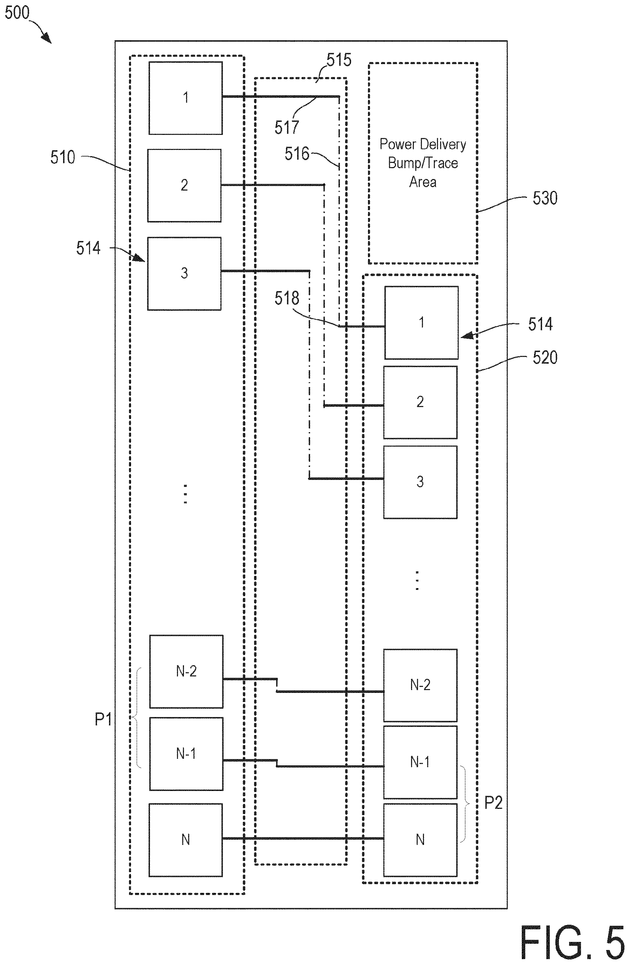

Referring now to FIG. 5, the example interconnect bridge circuitry design 500 is somewhat similar to the design 400 of FIG. 4 in that it incorporates an incremental difference in the length of the jogs across the shorelines. However, in contrast to the example shown in FIG. 4, the jog length in FIG. 5 may be zero or close to zero towards one end of the shoreline and incrementally grow across the length of the design 500. For instance, in the example shown, the jogs at the bottom end of the design in FIG. 5 are shorter than the jogs at the upper end of the design in FIG. 5.

Like the design 400, the example design 500 includes a first region 510 that includes a first shoreline of N bridge-to-die connectors 512, a second region 520 that includes a second shoreline of N bridge-to-die connectors 414, and a third region 515 between the first region 510 and the second region 520 that includes jogs (e.g., 516) interconnecting the traces (e.g., 517) extending from the first connectors and the traces (e.g., 518) extending from the second connectors. Moreover, like the previous example, the first shoreline of connectors 512 has a lower "density" of connectors than the second shoreline of connectors 514. That is, the pitch of the connectors 512 (P1) is larger than the pitch of the connectors 514 (P2). However, in this example design, there is one region 530 that is dedicated for placement of power delivery bumps, traces, and/or power meshes, e.g., as described above. The region 530 is located on the same side of the layout as the second shoreline due to the second shoreline's higher density of connectors than the first shoreline.

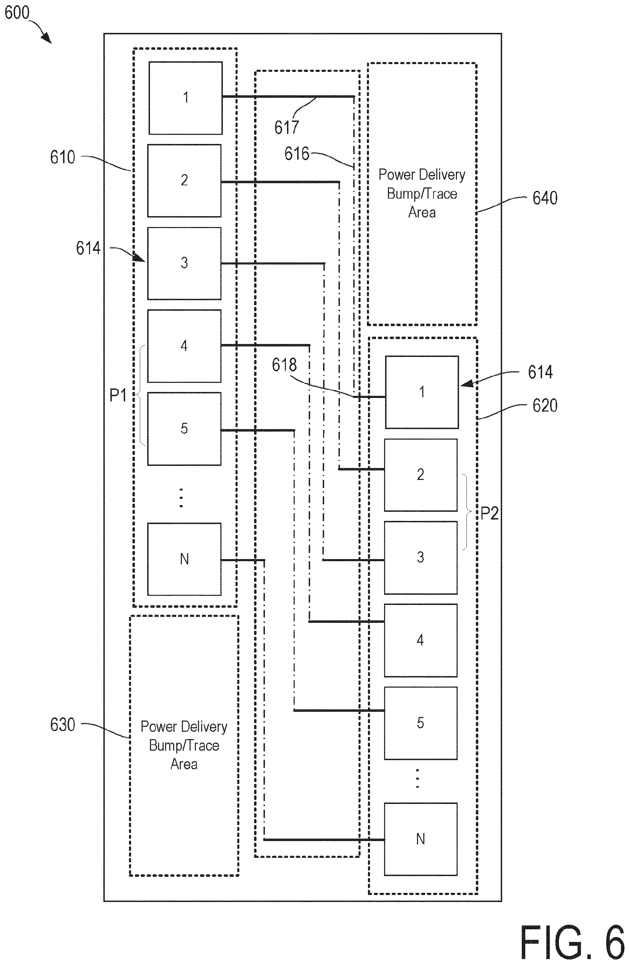

In each of the designs of FIGS. 4, 5, due to the incremental offset of the jog lengths, the jog routes can be built on a hierarchical level for design efficiency purposes. However, other designs. For example, the design 600 shown in FIG. 6 includes jogs that are all the same length. This is because the example design 600, like the other examples, includes a first region 610 that includes a first shoreline of N bridge-to-die connectors 612, a second region 620 that includes a second shoreline of N bridge-to-die connectors 614, and a third region 615 between the first region 610 and the second region 620 that includes jogs (e.g., 616) interconnecting the traces (e.g., 617) extending from the first connectors and the traces (e.g., 618) extending from the second connectors. Like the previous examples, the pitch of the connectors 612 (P1) is larger than the pitch of the connectors 614 (P2). However, unlike the previous examples, the shorelines have the same connector density and are just offset in the design 600. This may allow for increased routing area for breakouts, e.g., as described above with respect to FIG. 2B. The offset of the shorelines in the example design 600 thus allows for additional regions 630, 640 adjacent each shoreline, which can be dedicated for placement of power delivery bumps, traces, and/or power meshes (as indicated within the regions shown in FIG. 6).

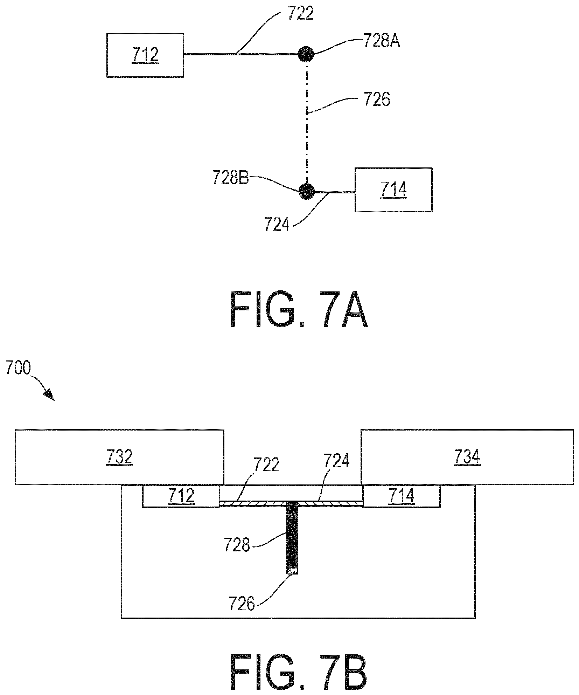

FIGS. 7A-7B illustrate top and side views, respectively, of a die-to-die interconnect of a bridge circuitry in accordance with embodiments herein. The example shown may represent a generalized model of how the interconnects between two bridge-to-die connectors of an interconnect bridge circuitry 700, such as that of an interconnect bridge circuitry die. In the example shown, the bridge circuitry 700 includes a first bridge-to-die connector 712, which may represent one of many in a first shoreline of bridge-to-die connectors as described above, and also includes a second bridge-to-die connector 714, which may represent one of many in a second shoreline of bridge-to-die connectors as described above. The bridge circuitry 700 further includes a first trace 722 extending from the first connector 712 and a second trace 724 extending from the second connector 714. The example traces 722, 724 are implemented in the same metallization layer of the circuitry 700, but may be implemented in different and/or other layers in other embodiments. There is further a jog 726 implemented in a different metallization layer than the traces 722, 724. The jog 726 is connected to each of the traces 722, 724 by a via 728A, 728B, respectively, and serves to interconnect the traces 722, 724 as shown to create a die-to-die interconnect between two integrated circuit dies 732, 734 as shown.

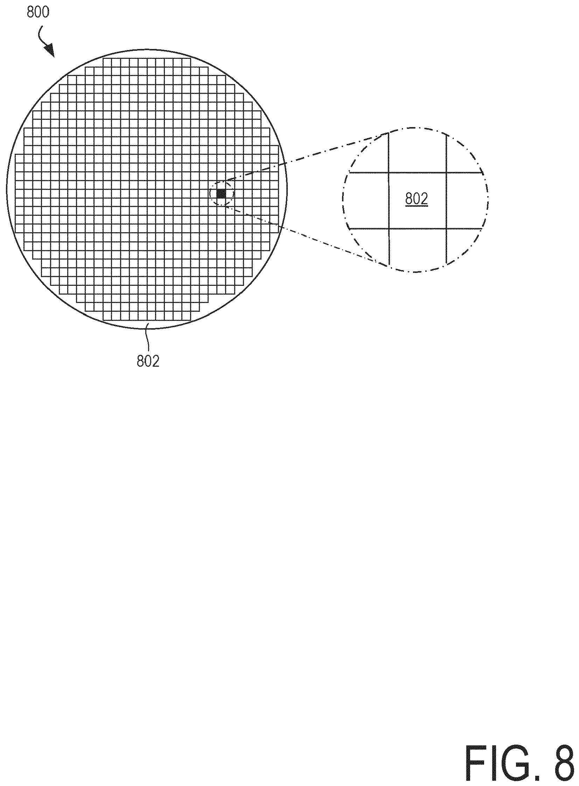

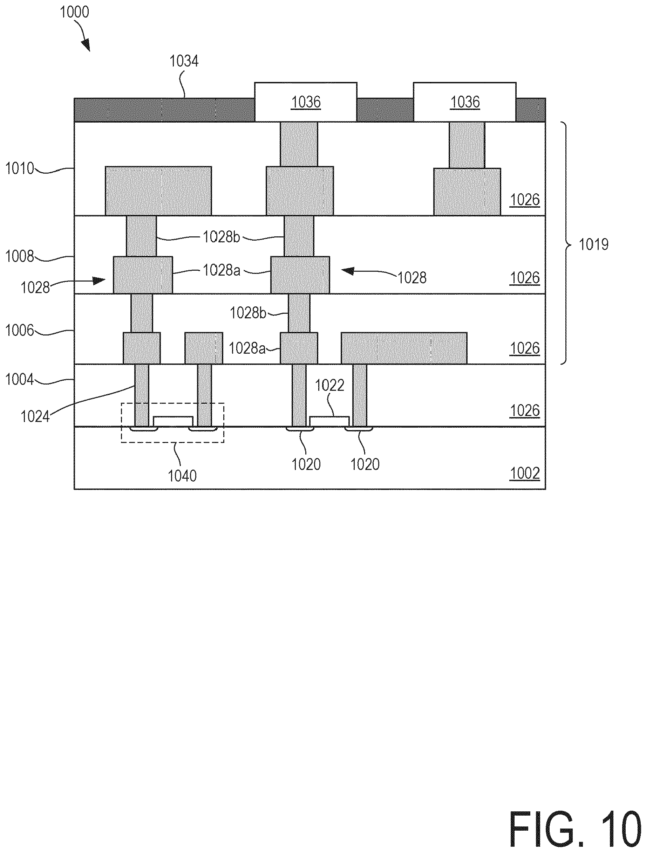

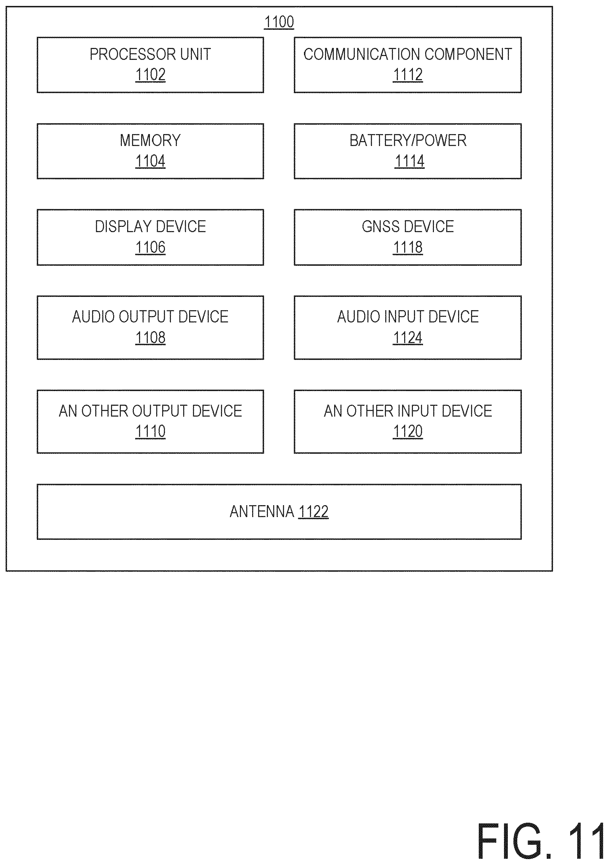

FIG. 8 is a top view of a wafer 800 and dies 802 that may be implemented in or along with any of the embodiments disclosed herein. The wafer 800 may be composed of semiconductor material and may include one or more dies 802 having integrated circuit structures formed on a surface of the wafer 800. The individual dies 802 may be a repeating unit of an integrated circuit product that includes any suitable integrated circuit. After the fabrication of the semiconductor product is complete, the wafer 800 may undergo a singulation process in which the dies 802 are separated from one another to provide discrete "chips" of the integrated circuit product. The die 802 may include one or more transistors (e.g., some of the transistors 1040 of FIG. 10, discussed below), supporting circuitry to route electrical signals to the transistors, passive components (e.g., signal traces, resistors, capacitors, or inductors), and/or any other integrated circuit components. In some embodiments, the wafer 800 or the die 802 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 802. For example, a memory array formed by multiple memory devices may be formed on a same die 802 as a processor unit (e.g., the processor unit 1102 of FIG. 11) or other logic that is configured to store information in the memory devices or execute instructions stored in the memory array.

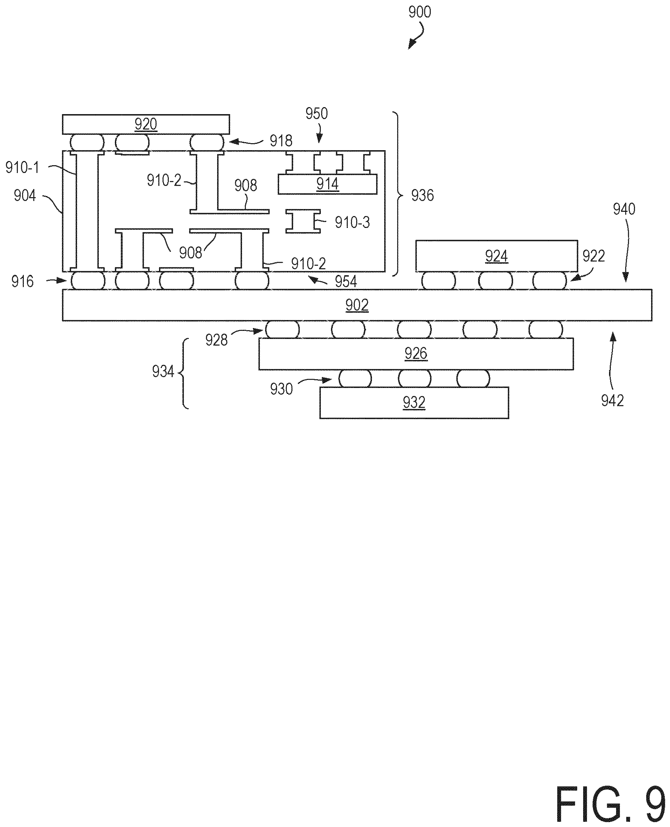

FIG. 9 is a cross-sectional side view of an integrated circuit device assembly 900 that may include any of the embodiments disclosed herein. The integrated circuit device assembly 900 includes a number of components disposed on a circuit board 902 (which may be a motherboard, system board, mainboard, etc.). The integrated circuit device assembly 900 includes components disposed on a first face 940 of the circuit board 902 and an opposing second face 942 of the circuit board 902; generally, components may be disposed on one or both faces 940 and 942.

In some embodiments, the circuit board 902 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 902. In other embodiments, the circuit board 902 may be a non-PCB substrate. The integrated circuit device assembly 900 illustrated in FIG. 9 includes a package-on-interposer structure 936 coupled to the first face 940 of the circuit board 902 by coupling components 916. The coupling components 916 may electrically and mechanically couple the package-on-interposer structure 936 to the circuit board 902, and may include solder balls (as shown in FIG. 9), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 936 may include an integrated circuit component 920 coupled to an interposer 904 by coupling components 918. The coupling components 918 may take any suitable form for the application, such as the forms discussed above with reference to the coupling components 916. Although a single integrated circuit component 920 is shown in FIG. 9, multiple integrated circuit components may be coupled to the interposer 904; indeed, additional interposers may be coupled to the interposer 904. The interposer 904 may provide an intervening substrate used to bridge the circuit board 902 and the integrated circuit component 920.

The integrated circuit component 920 may be a packaged or unpacked integrated circuit product that includes one or more integrated circuit dies (e.g., the die 802 of FIG. 8, the integrated circuit device 1000 of FIG. 10) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 920, a single monolithic integrated circuit die comprises solder bumps attached to contacts on the die. The solder bumps allow the die to be directly attached to the interposer 904. The integrated circuit component 920 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 920 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 920 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 920 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 904 may spread connections to a wider pitch or reroute a connection to a different connection. For example, the interposer 904 may couple the integrated circuit component 920 to a set of ball grid array (BGA) conductive contacts of the coupling components 916 for coupling to the circuit board 902. In the embodiment illustrated in FIG. 9, the integrated circuit component 920 and the circuit board 902 are attached to opposing sides of the interposer 904; in other embodiments, the integrated circuit component 920 and the circuit board 902 may be attached to a same side of the interposer 904. In some embodiments, three or more components may be interconnected by way of the interposer 904.

In some embodiments, the interposer 904 may be formed as a PCB, including multiple metal layers separated from one another by layers of dielectric material and interconnected by electrically conductive vias. In some embodiments, the interposer 904 may be formed of an epoxy resin, a fiberglass-reinforced epoxy resin, an epoxy resin with inorganic fillers, a ceramic material, or a polymer material such as polyimide. In some embodiments, the interposer 904 may be formed of alternate rigid or flexible materials that may include the same materials described above for use in a semiconductor substrate, such as silicon, germanium, and other group III-V and group IV materials. The interposer 904 may include metal interconnects 908 and vias 910, including but not limited to through hole vias 910-1 (that extend from a first face 950 of the interposer 904 to a second face 954 of the interposer 904), blind vias 910-2 (that extend from the first or second faces 950 or 954 of the interposer 904 to an internal metal layer), and buried vias 910-3 (that connect internal metal layers).

In some embodiments, the interposer 904 can comprise a silicon interposer. Through silicon vias (TSV) extending through the silicon interposer can connect connections on a first face of a silicon interposer to an opposing second face of the silicon interposer. In some embodiments, an interposer 904 comprising a silicon interposer can further comprise one or more routing layers to route connections on a first face of the interposer 904 to an opposing second face of the interposer 904.

The interposer 904 may further include embedded devices 914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 904. The package-on-interposer structure 936 may take the form of any of the package-on-interposer structures known in the art. In embodiments where the interposer is a non-printed circuit board

The integrated circuit device assembly 900 may include an integrated circuit component 924 coupled to the first face 940 of the circuit board 902 by coupling components 922. The coupling components 922 may take the form of any of the embodiments discussed above with reference to the coupling components 916, and the integrated circuit component 924 may take the form of any of the embodiments discussed above with reference to the integrated circuit component 920.

The integrated circuit device assembly 900 illustrated in FIG. 9 includes a package-on-package structure 934 coupled to the second face 942 of the circuit board 902 by coupling components 928. The package-on-package structure 934 may include an integrated circuit component 926 and an integrated circuit component 932 coupled together by coupling components 930 such that the integrated circuit component 926 is disposed between the circuit board 902 and the integrated circuit component 932. The coupling components 928 and 930 may take the form of any of the embodiments of the coupling components 916 discussed above, and the integrated circuit components 926 and 932 may take the form of any of the embodiments of the integrated circuit component 920 discussed above. The package-on-package structure 934 may be configured in accordance with any of the package-on-package structures known in the art.

FIG. 10 is a cross-sectional side view of an integrated circuit device 1000 that may be included in any of the embodiments disclosed herein. One or more of the integrated circuit devices 1000 may be included in one or more dies 802 (FIG. 8). The integrated circuit device 1000 may be formed on a die substrate 1002 (e.g., the wafer 800 of FIG. 8) and may be included in a die (e.g., the die 802 of FIG. 8). The die substrate 1002 may be a semiconductor substrate composed of semiconductor material systems including, for example, n-type or p-type materials systems (or a combination of both). The die substrate 1002 may include, for example, a crystalline substrate formed using a bulk silicon or a silicon-on-insulator (SOI) substructure. In some embodiments, the die substrate 1002 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1002. Although a few examples of materials from which the die substrate 1002 may be formed are described here, any material that may serve as a foundation for an integrated circuit device 1000 may be used. The die substrate 1002 may be part of a singulated die (e.g., the dies 802 of FIG. 8) or a wafer (e.g., the wafer 800 of FIG. 8).

The integrated circuit device 1000 may include one or more device layers 1004 disposed on the die substrate 1002. The device layer 1004 may include features of one or more transistors 1040 (e.g., metal oxide semiconductor field-effect transistors (MOSFETs)) formed on the die substrate 1002. The transistors 1040 may include, for example, one or more source and/or drain (S/D) regions 1020, a gate 1022 to control current flow between the S/D regions 1020, and one or more S/D contacts 1024 to route electrical signals to/from the S/D regions 1020. The transistors 1040 may include additional features not depicted for the sake of clarity, such as device isolation regions, gate contacts, and the like. The transistors 1040 are not limited to the type and configuration depicted in FIG. 10 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

Returning to FIG. 10, a transistor 1040 may include a gate 1022 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1040 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1040 along the source-channel-drain direction, the gate electrode may consist of a U-shaped structure that includes a bottom portion substantially parallel to the surface of the die substrate 1002 and two sidewall portions that are substantially perpendicular to the top surface of the die substrate 1002. In other embodiments, at least one of the metal layers that form the gate electrode may simply be a planar layer that is substantially parallel to the top surface of the die substrate 1002 and does not include sidewall portions substantially perpendicular to the top surface of the die substrate 1002. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1020 may be formed within the die substrate 1002 adjacent to the gate 1022 of individual transistors 1040. The S/D regions 1020 may be formed using an implantation/diffusion process or an etching/deposition process, for example. In the former process, dopants such as boron, aluminum, antimony, phosphorous, or arsenic may be ion-implanted into the die substrate 1002 to form the S/D regions 1020. An annealing process that activates the dopants and causes them to diffuse farther into the die substrate 1002 may follow the ion-implantation process. In the latter process, the die substrate 1002 may first be etched to form recesses at the locations of the S/D regions 1020. An epitaxial deposition process may then be carried out to fill the recesses with material that is used to fabricate the S/D regions 1020. In some implementations, the S/D regions 1020 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1020 may be formed using one or more alternate semiconductor materials such as germanium or a group III-V material or alloy. In further embodiments, one or more layers of metal and/or metal alloys may be used to form the S/D regions 1020.

Electrical signals, such as power and/or input/output (I/O) signals, may be routed to and/or from the devices (e.g., transistors 1040) of the device layer 1004 through one or more interconnect layers disposed on the device layer 1004 (illustrated in FIG. 10 as interconnect layers 1006-1010). For example, electrically conductive features of the device layer 1004 (e.g., the gate 1022 and the S/D contacts 1024) may be electrically coupled with the interconnect structures 1028 of the interconnect layers 1006-1010. The one or more interconnect layers 1006-1010 may form a metallization stack (also referred to as an "ILD stack") 1019 of the integrated circuit device 1000.

The interconnect structures 1028 may be arranged within the interconnect layers 1006-1010 to route electrical signals according to a wide variety of designs; in particular, the arrangement is not limited to the particular configuration of interconnect structures 1028 depicted in FIG. 10. Although a particular number of interconnect layers 1006-1010 is depicted in FIG. 10, embodiments of the present disclosure include integrated circuit devices having more or fewer interconnect layers than depicted.

In some embodiments, the interconnect structures 1028 may include lines 1028a and/or vias 1028b filled with an electrically conductive material such as a metal. The lines 1028a may be arranged to route electrical signals in a direction of a plane that is substantially parallel with a surface of the die substrate 1002 upon which the device layer 1004 is formed. For example, the lines 1028a may route electrical signals in a direction in and out of the page and/or in a direction across the page from the perspective of FIG. 10. The vias 1028b may be arranged to route electrical signals in a direction of a plane that is substantially perpendicular to the surface of the die substrate 1002 upon which the device layer 1004 is formed. In some embodiments, the vias 1028b may electrically couple lines 1028a of different interconnect layers 1006-1010 together.

The interconnect layers 1006-1010 may include a dielectric material 1026 disposed between the interconnect structures 1028, as shown in FIG. 10. In some embodiments, dielectric material 1026 disposed between the interconnect structures 1028 in different ones of the interconnect layers 1006-1010 may have different compositions; in other embodiments, the composition of the dielectric material 1026 between different interconnect layers 1006-1010 may be the same. The device layer 1004 may include a dielectric material 1026 disposed between the transistors 1040 and a bottom layer of the metallization stack as well. The dielectric material 1026 included in the device layer 1004 may have a different composition than the dielectric material 1026 included in the interconnect layers 1006-1010; in other embodiments, the composition of the dielectric material 1026 in the device layer 1004 may be the same as a dielectric material 1026 included in any one of the interconnect layers 1006-1010.

A first interconnect layer 1006 (referred to as Metal 1 or "M1") may be formed directly on the device layer 1004. In some embodiments, the first interconnect layer 1006 may include lines 1028a and/or vias 1028b, as shown. The lines 1028a of the first interconnect layer 1006 may be coupled with contacts (e.g., the S/D contacts 1024) of the device layer 1004. The vias 1028b of the first interconnect layer 1006 may be coupled with the lines 1028a of a second interconnect layer 1008.

The second interconnect layer 1008 (referred to as Metal 2 or "M2") may be formed directly on the first interconnect layer 1006. In some embodiments, the second interconnect layer 1008 may include via 1028b to couple the interconnect structures 1028 of the second interconnect layer 1008 with the lines 1028a of a third interconnect layer 1010. Although the lines 1028a and the vias 1028b are structurally delineated with a line within individual interconnect layers for the sake of clarity, the lines 1028a and the vias 1028b may be structurally and/or materially contiguous (e.g., simultaneously filled during a dual-damascene process) in some embodiments.

The third interconnect layer 1010 (referred to as Metal 3 or "M3") (and additional interconnect layers, as desired) may be formed in succession on the second interconnect layer 1008 according to similar techniques and configurations described in connection with the second interconnect layer 1008 or the first interconnect layer 1006. In some embodiments, the interconnect layers that are "higher up" in the metallization stack 1019 in the integrated circuit device 1000 (i.e., farther away from the device layer 1004) may be thicker that the interconnect layers that are lower in the metallization stack 1019, with lines 1028a and vias 1028b in the higher interconnect layers being thicker than those in the lower interconnect layers.

The integrated circuit device 1000 may include a solder resist material 1034 (e.g., polyimide or similar material) and one or more conductive contacts 1036 formed on the interconnect layers 1006-1010. In FIG. 10, the conductive contacts 1036 are illustrated as taking the form of bond pads. The conductive contacts 1036 may be electrically coupled with the interconnect structures 1028 and configured to route the electrical signals of the transistor(s) 1040 to external devices. For example, solder bonds may be formed on the one or more conductive contacts 1036 to mechanically and/or electrically couple an integrated circuit die including the integrated circuit device 1000 with another component (e.g., a printed circuit board or a package substrate, e.g., 112). The integrated circuit device 1000 may include additional or alternate structures to route the electrical signals from the interconnect layers 1006-1010; for example, the conductive contacts 1036 may include other analogous features (e.g., posts) that route the electrical signals to external components.

In some embodiments in which the integrated circuit device 1000 is a double-sided die, the integrated circuit device 1000 may include another metallization stack (not shown) on the opposite side of the device layer(s) 1004. This metallization stack may include multiple interconnect layers as discussed above with reference to the interconnect layers 1006-1010, to provide conductive pathways (e.g., including conductive lines and vias) between the device layer(s) 1004 and additional conductive contacts (not shown) on the opposite side of the integrated circuit device 1000 from the conductive contacts 1036.

In other embodiments in which the integrated circuit device 1000 is a double-sided die, the integrated circuit device 1000 may include one or more through silicon vias (TSVs) through the die substrate 1002; these TSVs may make contact with the device layer(s) 1004, and may provide conductive pathways between the device layer(s) 1004 and additional conductive contacts (not shown) on the opposite side of the integrated circuit device 1000 from the conductive contacts 1036. In some embodiments, TSVs extending through the substrate can be used for routing power and ground signals from conductive contacts on the opposite side of the integrated circuit device 1000 from the conductive contacts 1036 to the transistors 1040 and any other components integrated into the integrated circuit device 1000, and the metallization stack 1019 can be used to route I/O signals from the conductive contacts 1036 to transistors 1040 and any other components integrated into the integrated circuit device 1000.

Multiple integrated circuit devices 1000 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

FIG. 11 is a block diagram of an example electrical device 1100 that may include one or more of the embodiments disclosed herein. For example, any suitable ones of the components of the electrical device 1100 may include one or more of integrated circuit devices 1000, or integrated circuit dies 802 disclosed herein. A number of components are illustrated in FIG. 11 as included in the electrical device 1100, but any one or more of these components may be omitted or duplicated, as suitable for the application. In some embodiments, some or all of the components included in the electrical device 1100 may be attached to one or more motherboards mainboards, or system boards. In some embodiments, one or more of these components are fabricated onto a single system-on-a-chip (SoC) die.

Additionally, in various embodiments, the electrical device 1100 may not include one or more of the components illustrated in FIG. 11, but the electrical device 1100 may include interface circuitry for coupling to the one or more components. For example, the electrical device 1100 may not include a display device 1106, but may include display device interface circuitry (e.g., a connector and driver circuitry) to which a display device 1106 may be coupled. In another set of examples, the electrical device 1100 may not include an audio input device 1124 or an audio output device 1108, but may include audio input or output device interface circuitry (e.g., connectors and supporting circuitry) to which an audio input device 1124 or audio output device 1108 may be coupled.

The electrical device 1100 may include one or more processor units 1102 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1102 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1100 may include a memory 1104, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1104 may include memory that is located on the same integrated circuit die as the processor unit 1102. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1100 can comprise one or more processor units 1102 that are heterogeneous or asymmetric to another processor unit 1102 in the electrical device 1100. There can be a variety of differences between the processing units 1102 in a system in terms of a spectrum of metrics of merit including architectural, microarchitectural, thermal, power consumption characteristics, and the like. These differences can effectively manifest themselves as asymmetry and heterogeneity among the processor units 1102 in the electrical device 1100.

In some embodiments, the electrical device 1100 may include a communication component 1112 (e.g., one or more communication components). For example, the communication component 1112 can manage wireless communications for the transfer of data to and from the electrical device 1100. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1112 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1112 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1112 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1112 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1112 may operate in accordance with other wireless protocols in other embodiments. The electrical device 1100 may include an antenna 1122 to facilitate wireless communications and/or to receive other wireless communications (such as AM or FM radio transmissions).

In some embodiments, the communication component 1112 may manage wired communications, such as electrical, optical, or any other suitable communication protocols (e.g., IEEE 802.3 Ethernet standards). As noted above, the communication component 1112 may include multiple communication components. For instance, a first communication component 1112 may be dedicated to shorter-range wireless communications such as Wi-Fi or Bluetooth, and a second communication component 1112 may be dedicated to longer-range wireless communications such as global positioning system (GPS), EDGE, GPRS, CDMA, WiMAX, LTE, EV-DO, or others. In some embodiments, a first communication component 1112 may be dedicated to wireless communications, and a second communication component 1112 may be dedicated to wired communications.

The electrical device 1100 may include battery/power circuitry 1114. The battery/power circuitry 1114 may include one or more energy storage devices (e.g., batteries or capacitors) and/or circuitry for coupling components of the electrical device 1100 to an energy source separate from the electrical device 1100 (e.g., AC line power).

The electrical device 1100 may include a display device 1106 (or corresponding interface circuitry, as discussed above). The display device 1106 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1100 may include an audio output device 1108 (or corresponding interface circuitry, as discussed above). The audio output device 1108 may include any embedded or wired or wirelessly connected external device that generates an audible indicator, such speakers, headsets, or earbuds.

The electrical device 1100 may include an audio input device 1124 (or corresponding interface circuitry, as discussed above). The audio input device 1124 may include any embedded or wired or wirelessly connected device that generates a signal representative of a sound, such as microphones, microphone arrays, or digital instruments (e.g., instruments having a musical instrument digital interface (MIDI) output). The electrical device 1100 may include a Global Navigation Satellite System (GNSS) device 1118 (or corresponding interface circuitry, as discussed above), such as a Global Positioning System (GPS) device. The GNSS device 1118 may be in communication with a satellite-based system and may determine a geolocation of the electrical device 1100 based on information received from one or more GNSS satellites, as known in the art.

The electrical device 1100 may include another output device 1110 (or corresponding interface circuitry, as discussed above). Examples of the other output device 1110 may include an audio codec, a video codec, a printer, a wired or wireless transmitter for providing information to other devices, or an additional storage device.

The electrical device 1100 may include another input device 1120 (or corresponding interface circuitry, as discussed above). Examples of the other input device 1120 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1100 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1100 may be any other electronic device that processes data. In some embodiments, the electrical device 1100 may comprise multiple discrete physical components. Given the range of devices that the electrical device 1100 can be manifested as in various embodiments, in some embodiments, the electrical device 1100 can be referred to as a computing device or a computing system.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 is an apparatus comprising: a first set of bridge-to-die electrical connectors in a first region of the appartaus; a second set of bridge-to-die electrical connectors in a second region of the appartaus; and interconnections between respective pairs of bridge-to-die connectors of the first set and the second set in a third region of the apparatus between the first region and the second region, each interconnection comprising: a first trace connected to the bridge-to-die electrical connector of the first set; a second trace connected to the bridge-to-die electrical connector of the second set; a third trace connected between the first trace and the second trace, the third trace in a different metallization layer of the apparatus than the first trace and the second trace.

Example 2 includes the subject matter of Example 1, wherein the first set of bridge-to-die electrical connectors is offset from the second set of bridge-to-die electrical connectors.

Example 3 includes the subject matter of Example 1 or 2, wherein the third trace of each interconnection is orthogonal to the first trace and the second trace of the interconnection.

Example 4 includes the subject matter of any one of Examples 1-3, wherein the first trace and second trace of each interconnection is in a first metallization level of the apparatus, and the third trace is in a second metallization level of the apparatus.

Example 5 includes the subject matter of any one of Examples 1-4, wherein a density of the first set of bridge-to-die electrical connectors in the first region is less than a density of the first set of bridge-to-die electrical connectors in the second region, or wherein a pitch of the first set of bridge-to-die electrical connectors in the first region is greater than a pitch of the first set of bridge-to-die electrical connectors in the second region.

Example 6 includes the subject matter of Example 5, wherein each third trace of the interconnections is incrementally longer or incrementally shorter than an adjacent third trace of the interconnections.

Example 7 includes the subject matter of Example 5 or 6, further comprising a set of electrical connectors or traces in a fourth region of the apparatus adjacent the second region, the electrical connectors or traces in the fourth region not connected to circuitry within the first region, second region, or third region.

Example 8 includes the subject matter of Example 7, further comprising a set of electrical connectors or traces in a fifth region of the apparatus adjacent the second region on an opposite side of the second region than the fourth region, the electrical connectors or traces in the fifth region not connected to circuitry within the first region, second region, or third region.

Example 9 includes the subject matter of any one of Examples 1-4, wherein a density/pitch of the first set of bridge-to-die electrical connectors in the first region is the same as a density/pitch of the first set of bridge-to-die electrical connectors in the second region.

Example 10 includes the subject matter of Example 9, wherein the third traces of the interconnections are the same length.

Example 11 includes the subject matter of Example 9 or 10, further comprising a set of electrical connectors or traces in a fourth region of the apparatus adjacent the first region, the electrical connectors or traces in the fourth region not connected to circuitry within the first region, second region, or third region.

Example 12 includes the subject matter of any one of Examples 9-11, further comprising a set of electrical connectors or traces in a fourth region of the apparatus adjacent the second region, the electrical connectors or traces in the fourth region not connected to circuitry within the first region, second region, or third region.

Example 13 includes the subject matter of any one of Examples 1-12, wherein the apparatus comprises an interconnect bridge circuitry die.

Example 14 is an integrated circuit package substrate comprising: an interconnect bridge circuitry die comprising: a first set of bridge-to-die electrical connectors in a first region; a second set of bridge-to-die electrical connectors in a second region; and interconnections between respective pairs of bridge-to-die connectors of the first set and the second set in a third region between the first region and the second region, each interconnection comprising: a first trace connected to the bridge-to-die electrical connector of the first set; a second trace connected to the bridge-to-die electrical connector of the second set; a third trace connected between the first trace and the second trace, the third trace in a different metallization layer of the interconnect bridge circuitry than the first trace and the second trace.

Example 15 includes the subject matter of Example 14, wherein the first set of bridge-to-die electrical connectors is offset from the second set of bridge-to-die electrical connectors.

Example 16 includes the subject matter of Example 14 or 15, wherein the first trace and second trace of each interconnection is in a first metallization level of the apparatus, and the third trace is in a second metallization level of the apparatus.

Example 17 includes the subject matter of any one of Examples 14-16, wherein a density of the first set of bridge-to-die electrical connectors in the first region is less than a density of the first set of bridge-to-die electrical connectors in the second region, or wherein a pitch of the first set of bridge-to-die electrical connectors in the first region is greater than a pitch of the first set of bridge-to-die electrical connectors in the second region..

Example 18 is an integrated circuit package comprising: a package substrate; a first integrated circuit die; a second integrated circuit die; bridge circuitry to interconnect the first integrated circuit die and the second integrated circuit die, the bridge circuitry comprising: a first set of bridge-to-die electrical connectors in a first region of the bridge circuitry, the first set of bridge-to-die electrical connectors connected to the first integrated circuit die; a second set of bridge-to-die electrical connectors in a second region of the bridge circuitry, the second set of bridge-to-die electrical connectors connected to the second integrated circuit die; and interconnections between respective pairs of bridge-to-die connectors of the first set and the second set in a third region between the first region and the second region, each interconnection comprising a trace connecting the connector of the first set of bridge-to-die connectors and the connector of the second set of bridge-to-die connectors, the trace in a different metallization layer than the first set of bridge-to-die connectors and the second set of bridge-to-die connectors.

Example 19 includes the subject matter of Example 18, wherein the bridge circuitry is in a bridge circuitry die, the bridge circuitry die embedded in a cavity of the package substrate.

Example 20 includes the subject matter of Example 18 or 19, wherein the bridge circuitry further comprises circuitry (e.g., electrical traces or connections) in a fourth region to provide power signals to the first integrated circuit die or to the second integrated circuit die.

Example 21 is integrated circuit package substrate comprising an interconnect bridge circuitry die comprising the apparatus of any one of Examples 1-13.

Example 22 is an integrated circuit package comprising: a first integrated circuit die; a second integrated circuit die; and an integrated package substrate according to Example 21.

Example 23 is an integrated circuit package substrate comprising: an interconnect bridge circuitry die comprising: a first set of bridge-to-die electrical connectors in a first region; a second set of bridge-to-die electrical connectors in a second region; and interconnections between respective pairs of bridge-to-die connectors of the first set and the second set in a third region between the first region and the second region, each interconnection comprising a trace in a different metallization layer of the interconnect bridge circuitry than the first set of bridge-to-die electrical connectors and the second set of bridge-to-die electrical connectors.

Example 24 includes the subject matter of Example 23, wherein the first set of bridge-to-die electrical connectors is offset from the second set of bridge-to-die electrical connectors.

Example 25 includes the subject matter of Example 23 or 24, wherein a density of the first set of bridge-to-die electrical connectors in the first region is less than a density of the first set of bridge-to-die electrical connectors in the second region, or wherein a pitch of the first set of bridge-to-die electrical connectors in the first region is greater than a pitch of the first set of bridge-to-die electrical connectors in the second region.

Example 26 includes the subject matter of Example 23 or 24, wherein a density/pitch of the first set of bridge-to-die electrical connectors in the first region is the same as a density/pitch of the first set of bridge-to-die electrical connectors in the second region.

Example 27 is an integrated circuit package substrate comprising: an interconnect bridge circuitry die comprising: a first set of bridge-to-die electrical connectors in a first region; a second set of bridge-to-die electrical connectors in a second region; and interconnections between respective pairs of bridge-to-die connectors of the first set and the second set in a third region between the first region and the second region, each interconnection comprising a trace connecting the connector of the first set of bridge-to-die connectors and the connector of the second set of bridge-to-die connectors, the trace in a different metallization layer than the first set of bridge-to-die connectors and the second set of bridge-to-die connectors

Example 28 includes the subject matter of Example 27, wherein the first set of bridge-to-die electrical connectors is offset from the second set of bridge-to-die electrical connectors.

Example 29 includes the subject matter of Example 27 or 28, wherein a density of the first set of bridge-to-die electrical connectors in the first region is less than a density of the first set of bridge-to-die electrical connectors in the second region, or wherein a pitch of the first set of bridge-to-die electrical connectors in the first region is greater than a pitch of the first set of bridge-to-die electrical connectors in the second region..

Example 30 includes the subject matter of Example 27 or 28, wherein a density/pitch of the first set of bridge-to-die electrical connectors in the first region is the same as a density/pitch of the first set of bridge-to-die electrical connectors in the second region.

Example 31 is an apparatus comprising: a first set of bridge-to-die electrical connectors in a first region of the apparatus; a second set of bridge-to-die electrical connectors in a second region of the apparatus; and an interconnection between a bridge-to-die connector of the first set and a bridge-to-die connector of the second set, the interconnection in a third region of the apparatus between the first region and the second region, the interconnection comprising: a first trace connected to the bridge-to-die electrical connector of the first set; a second trace connected to the bridge-to-die electrical connector of the second set, the second trace parallel with the first trace; and a third trace connected between the first trace and the second trace.

Example 32 includes the subject matter of Example 31, wherein the first set of bridge-to-die electrical connectors is offset from the second set of bridge-to-die electrical connectors.

Example 33 includes the subject matter of Example 31 or 32, wherein the third trace of the interconnection is orthogonal to the first trace and the second trace of the interconnection.

Example 34 includes the subject matter of any one of Examples 31-33, wherein the third trace is in a different metallization layer of the apparatus than the first trace and the second trace.

Example 35 includes the subject matter of any one of Examples 31-34, wherein a pitch of the first set of bridge-to-die electrical connectors in the first region is greater than a pitch of the first set of bridge-to-die electrical connectors in the second region.

Example 36 includes the subject matter of any one of Examples 31-34, wherein a pitch of the first set of bridge-to-die electrical connectors in the first region is the same as a pitch of the first set of bridge-to-die electrical connectors in the second region.

Example 37 includes the subject matter of any one of Examples 31-36, further comprising a set of electrical connectors or traces in a fourth region of the apparatus adjacent the first region, the electrical connectors or traces in the fourth region not connected to circuitry within the first region, second region, or third region.

Example 38 includes the subject matter of Example 37, further comprising a set of electrical connectors or traces in a fourth region of the apparatus adjacent the second region, the electrical connectors or traces in the fourth region not connected to circuitry within the first region, second region, or third region.

Example 39 is an integrated circuit package substrate comprising: an interconnect bridge circuitry comprising: a first set of bridge-to-die electrical connectors in a first region; a second set of bridge-to-die electrical connectors in a second region; and interconnections between respective pairs of bridge-to-die connectors of the first set and the second set in a third region between the first region and the second region, each interconnection comprising a jog between a first trace extending from the connector of the first set of bridge-to-die connectors and a second trace extending from the connector of the second set of bridge-to-die connectors.

Example 40 includes the subject matter of Example 39, wherein the first set of bridge-to-die electrical connectors is offset from the second set of bridge-to-die electrical connectors.

Example 41 includes the subject matter of Example 39 or 40, wherein a pitch of the first set of bridge-to-die electrical connectors in the first region is greater than a pitch of the first set of bridge-to-die electrical connectors in the second region.

Example 42 includes the subject matter of Example 41, wherein the jog of the interconnections is incrementally longer or incrementally shorter than an adjacent jog of the interconnections.

Example 43 includes the subject matter of Example 41, further comprising circuitry in a fourth region of the apparatus adjacent the second region, the circuitry in the fourth region not connected to circuitry within the first region, second region, or third region.

Example 44 includes the subject matter of Example 43, further comprising circuitry in a fifth region of the apparatus adjacent the second region on an opposite side of the second region than the fourth region, the circuitry in the fifth region not connected to circuitry within the first region, second region, or third region.

Example 45 includes the subject matter of Example 39 or 40, wherein a pitch of the first set of bridge-to-die electrical connectors in the first region is the same as a pitch of the first set of bridge-to-die electrical connectors in the second region.

Example 46 includes the subject matter of Example 45, wherein the third traces of the interconnections are the same length.

Example 47 includes the subject matter of Example 45, wherein the interconnect bridge circuitry is within a die embedded in the integrated circuit package substrate.

Example 48 is an integrated circuit package comprising: a package substrate; a first integrated circuit die; a second integrated circuit die; bridge circuitry to interconnect the first integrated circuit die and the second integrated circuit die, the bridge circuitry comprising: a first set of bridge-to-die electrical connectors in a first region of the bridge circuitry, the first set of bridge-to-die electrical connectors connected to the first integrated circuit die; a second set of bridge-to-die electrical connectors in a second region of the bridge circuitry, the second set of bridge-to-die electrical connectors connected to the second integrated circuit die; and interconnections between respective pairs of bridge-to-die connectors of the first set and the second set in a third region between the first region and the second region, each interconnection comprising a jog between a first trace extending from the connector of the first set of bridge-to-die connectors and a second trace extending from the connector of the second set of bridge-to-die connectors.

Example 49 includes the subject matter of Example 48, wherein the bridge circuitry is in a bridge circuitry die, the bridge circuitry die embedded in a cavity of the package substrate.

Example 50 includes the subject matter of Example 48 or 49, wherein the bridge circuitry further comprises circuitry in a fourth region to provide power signals to the first integrated circuit die or to the second integrated circuit die.

In the above description, various aspects of the illustrative implementations have been described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials, and configurations have been set forth to provide a thorough understanding of the illustrative implementations. However, it will be apparent to one skilled in the art that the present disclosure may be practiced without all of the specific details. In other instances, well-known features have been omitted or simplified in order not to obscure the illustrative implementations.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C). Additionally, it should be appreciated that items included in a list in the form of "at least one of A, B, and C" can mean (A); (B); (C); (A and B); (A and C); (B and C); or (A, B, and C). Similarly, items listed in the form of "at least one of A, B, or C" can mean (A); (B); (C); (A and B); (A and C); (B and C); or (A, B, and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The above description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact. Further, "adjacent" may refer to layers or components that are in physical contact with each other. That is, there is no layer or component between the stated adjacent layers or components. For example, a layer X that is adjacent to a layer Y refers to a layer that is in physical contact with layer Y.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature. Further, "located on" in the context of a first layer or component located on a second layer or component may refer to the first layer or component being directly physically attached to the second part or component (no layers or components between the first and second layers or components) or physically attached to the second layer or component with one or more intervening layers or components.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

## Claims

1. An apparatus comprising:
a first set of bridge-to-die electrical connectors in a first region of the apparatus;
a second set of bridge-to-die electrical connectors in a second region of the apparatus; and
an interconnection between a bridge-to-die connector of the first set and a bridge-to-die connector of the second set, the interconnection in a third region of the apparatus between the first region and the second region, the interconnection comprising:
a first trace connected to the bridge-to-die electrical connector of the first set;
a second trace connected to the bridge-to-die electrical connector of the second set, the second trace parallel with the first trace; and
a third trace connected between the first trace and the second trace.

2. The apparatus of claim 1, wherein the first set of bridge-to-die electrical connectors is offset from the second set of bridge-to-die electrical connectors.

3. The apparatus of claim 1 or 2, wherein the third trace of the interconnection is orthogonal to the first trace and the second trace of the interconnection.

4. The apparatus of any one of claims 1-3, wherein the third trace is in a different metallization layer of the apparatus than the first trace and the second trace.

5. The apparatus of any one of claim 1-4, wherein a pitch of the first set of bridge-to-die electrical connectors in the first region is greater than a pitch of the first set of bridge-to-die electrical connectors in the second region.

6. The apparatus of any one of claim 1-4, wherein a pitch of the first set of bridge-to-die electrical connectors in the first region is the same as a pitch of the first set of bridge-to-die electrical connectors in the second region.

7. The apparatus of any one of claims 1-6, further comprising a set of electrical connectors or traces in a fourth region of the apparatus adjacent the first region, the electrical connectors or traces in the fourth region not connected to circuitry within the first region, second region, or third region.

8. The apparatus of claim 7, further comprising a set of electrical connectors or traces in a fourth region of the apparatus adjacent the second region, the electrical connectors or traces in the fourth region not connected to circuitry within the first region, second region, or third region.

9. An integrated circuit package substrate comprising:
an interconnect bridge circuitry comprising:
a first set of bridge-to-die electrical connectors in a first region;
a second set of bridge-to-die electrical connectors in a second region; and
interconnections between respective pairs of bridge-to-die connectors of the first set and the second set in a third region between the first region and the second region, each interconnection comprising a jog between a first trace extending from the connector of the first set of bridge-to-die connectors and a second trace extending from the connector of the second set of bridge-to-die connectors.

10. The integrated circuit package substrate of claim 9, wherein the first set of bridge-to-die electrical connectors is offset from the second set of bridge-to-die electrical connectors.

11. The integrated circuit package substrate of claim 9 or 10, wherein a pitch of the first set of bridge-to-die electrical connectors in the first region is greater than a pitch of the first set of bridge-to-die electrical connectors in the second region.

12. The integrated circuit package substrate of claim 11, wherein the jog of the interconnections is incrementally longer or incrementally shorter than an adjacent jog of the interconnections.

13. The integrated circuit package substrate of claim 11, further comprising circuitry in a fourth region of the apparatus adjacent the second region, the circuitry in the fourth region not connected to circuitry within the first region, second region, or third region.

14. The integrated circuit package substrate of claim 13, further comprising circuitry in a fifth region of the apparatus adjacent the second region on an opposite side of the second region than the fourth region, the circuitry in the fifth region not connected to circuitry within the first region, second region, or third region.

15. The integrated circuit package substrate of claim 9 or 10, wherein a pitch of the first set of bridge-to-die electrical connectors in the first region is the same as a pitch of the first set of bridge-to-die electrical connectors in the second region.
